# EUROPEAN PATENT APPLICATION

(11) **EP 4 804 757 A1**
(43) Date of publication of application: **09.09.2026**
(21) Application number: 25173159.2
(22) Date of filing: 29.04.2025
(51) Int. Cl.: H10D 30/66, H10D 62/10, H10D 64/27, H10D 62/832

(54) **TRENCH POWER DEVICE**

(30) Priority: 03.03.2025 TW 114107621
(71) Applicant: Hon Hai Precision Industry Co., Ltd., 236 New Taipei City (TW)
(72) Inventor: HUNG, Chia-Lung, 236 New Taipei City (TW); HSIAO, Yi-Kai, 236 New Taipei City (TW); KUO, Hao-Chung, 236 New Taipei City (TW); OU, Tien Fan, 236 New Taipei City (TW); LI, Chung-Chih, 236 New Taipei City (TW); YAO, Jing Neng, 236 New Taipei City (TW); TSUI, Bing Yue, 236 New Taipei City (TW); HUANG, Huai-Lin, 236 New Taipei City (TW); CHEN, Wen-Shu, 236 New Taipei City (TW)
(74) Representative: Becker, Eberhard

(57) **Abstract**

Provided is a trench power device, which includes a substrate (100), an epitaxial layer (102), a trench gate structure (104, 200, 300, 400, 500), a drain layer (106), and a source region (108). The epitaxial layer (102) having a trench (112) is formed on a first surface (100a) of the substrate (100). The trench gate structure (104, 200, 300, 400, 500) is located in the trench (112). The drain layer (106) is located on a second surface (100b) of the substrate (100). The source region (108) is formed in the epitaxial layer (102) on both sides of the trench gate structure (104, 200, 300, 400, 500). The trench gate structure (104, 200, 300, 400, 500) includes a gate (114, 204, 304, 404) formed in the trench (112), a gate oxide layer (116) and a bottom dielectric layer (118, 202, 302, 402).

## Description

### BACKGROUND

### Technical Field

The disclosure relates to a power transistor technology, and particularly relates to a trench power device.

### Related Art

In the field of power devices, how to reduce the on-resistance to enhance power density is the direction that industry and academia are striving to develop. Therefore, compared with existing planar transistors, trench power devices with lower on-resistance have become the focus of research and development for power devices.

However, power devices with trench architecture have to be able to withstand high voltage at the bottom and corner regions of the trench. Without proper design and protection methods, it may lead to device leakage in minor cases, or direct device damage in severe cases.

### SUMMARY

The disclosure provides a trench power device, which may avoid the phenomenon of excessive electric field at the bottom and corner of a trench, thereby preventing device leakage and deterioration phenomenon of premature breakdown.

The trench power device of the disclosure includes a substrate, an epitaxial layer, a trench gate structure, a drain layer, and a source region. The substrate has a first surface and a second surface opposite to each other. The epitaxial layer is formed on the first surface of the substrate and has a trench. The trench gate structure is formed in the trench of the epitaxial layer. The drain layer is formed on the second surface of the substrate. The source region is formed in the epitaxial layer on both sides of the trench gate structure. The trench gate structure includes a gate, a gate oxide layer, and a bottom dielectric layer. The gate is formed in the trench. The gate oxide layer is formed between the gate and a sidewall of the trench. The bottom dielectric layer is formed between the gate and a bottom surface of the trench. A thickness of the bottom dielectric layer is greater than a thickness of the gate oxide layer, and a top of the bottom dielectric layer includes a convex curved surface.

Another trench power device of the disclosure includes a substrate, an epitaxial layer, a trench gate structure, a drain layer, and a source region. The substrate has a first surface and a second surface opposite to each other. The epitaxial layer is formed on the first surface of the substrate and has a trench. The trench gate structure is formed in the trench of the epitaxial layer. The drain layer is formed on the second surface of the substrate. The source region is formed in the epitaxial layer on both sides of the trench gate structure. The trench gate structure includes a gate, a gate oxide layer, and a bottom dielectric layer. The gate is formed in the trench. A bottom of the gate has a concave curved surface. The gate oxide layer is formed between the gate and a sidewall of the trench, and the bottom dielectric layer is formed between the gate and a bottom surface of the trench.

Based on the above, the trench power device of the disclosure has the bottom dielectric layer with a specific structure, which is disposed in the trench gate structure and may avoid the phenomenon of excessive electric field at the bottom and corner of the trench.

In order to make the features of the disclosure more comprehensible, the following examples are given and described in detail with the accompanying drawings as follows.

### BRIEF DESCRIPTION OF THE DRAWINGS

FIG. 1 is a schematic cross-sectional view of a trench power device according to an embodiment of the disclosure.
FIG. 2 is a schematic cross-sectional view of an example of a gate structure in a trench power device according to an embodiment of the disclosure.
FIG. 3A is a schematic cross-sectional view of another example of a gate structure in a trench power device according to an embodiment of the disclosure.
FIG. 3B is a perspective view of a bottom dielectric layer in the gate structure of FIG. 3A.
FIG. 4 is a schematic cross-sectional view of yet another example of a gate structure in a trench power device according to an embodiment of the disclosure.
FIG. 5 is a schematic cross-sectional view of still another example of a gate structure in a trench power device according to an embodiment of the disclosure.

### DESCRIPTION OF THE EMBODIMENTS

The embodiments are described in detail with reference to the accompanying drawings, but the embodiments are not intended to limit the scope of the disclosure. Furthermore, for the convenience of description, the dimensions of regions or layers in the drawings are not drawn to actual scale.

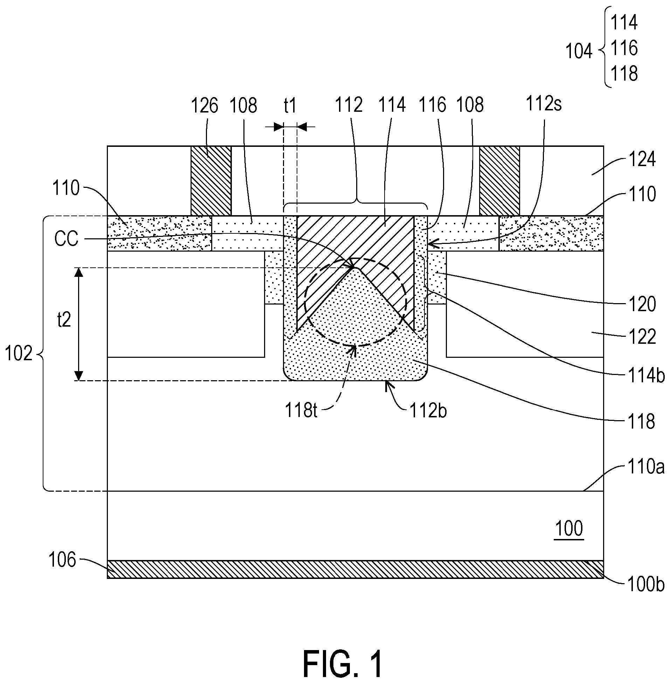

FIG. 1 is a schematic cross-sectional view of a trench power device according to an embodiment of the disclosure.

Please refer to FIG. 1. The trench power device of the embodiment includes a substrate 100, an epitaxial layer 102, a trench gate structure 104, a drain layer 106, and source regions 108. In some embodiments, the substrate 100 may be a semiconductor substrate, with a material such as Si, SiC, GaN, or GaAs. In other embodiments, the substrate 100 may be an insulating substrate, such as a glass substrate or a sapphire substrate. The substrate 100 has a first surface 100a and a second surface 100b opposite to each other. The epitaxial layer 102 is formed on the first surface 100a of the substrate 100 and has a trench 112. In some embodiments, the epitaxial layer 102 is, for example, a silicon carbide layer. The trench gate structure 104 is formed in the trench 112 of the epitaxial layer 102, that is, the trench gate structure 104 is located in the space composed by a sidewall 112s and a bottom surface 112b of the trench 112. The drain layer 106 is formed on the second surface 100b of the substrate 100. The source regions 108 are formed in the epitaxial layer 102 on both sides of the trench gate structure 104. In some embodiments, there are heavily doped regions 110 on both sides of the source region 108. The conductive type of the heavily doped region 110 is different from the conductive type of the source region 108, which may be used to stabilize the potential. In the embodiment, the source region 108 is, for example, an N+ region, and the heavily doped region 110 is, for example, a P+ region. The trench gate structure 104 includes a gate 114, a gate oxide layer 116, and a bottom dielectric layer 118. The gate 114 is formed in the trench 112. The gate oxide layer 116 is formed between the gate 114 and the sidewall 112s of the trench 112. The bottom dielectric layer 118 is formed between the gate 114 and the bottom surface 112b of the trench 112. In some embodiments, a material of the bottom dielectric layer 118 includes silicon oxide, silicon nitride or metal oxide. Atop 118t of the bottom dielectric layer 118 includes a convex curved surface CC. That is to say, the top 118t of the bottom dielectric layer 118 has a geometrical shape protruding upwards, and this protruding surface is curved, so this kind of structure may significantly reduce the electric field concentration effect caused by high voltage at the drain end at the bottom and corner of the trench 112, thereby enhancing the voltage withstanding capability of the device.

Please continue to refer to FIG. 1. A thickness t2 of the bottom dielectric layer 118 in the embodiment is greater than a thickness t1 of the gate oxide layer 116. The "thickness of the bottom dielectric layer" mentioned in the disclosure refers to a maximum thickness of the bottom dielectric layer 118, and even if not specifically marked, a minimum thickness of the bottom dielectric layer 118 may also be greater than the thickness t1 of the gate oxide layer 116. Therefore, the bottom dielectric layer 118 may also be called a "thick" dielectric layer, which may avoid a phenomenon of excessive electric field at the bottom and corner of the trench 112 in the trench power device, causing device leakage and deterioration phenomenon of premature breakdown. Moreover, a cross-section of the top 118t of the bottom dielectric layer 118 in FIG. 1 has a triangular profile, so during the deposition of the gate 114, a phenomenon of gate void caused by insufficient gap-filling capability of the gate material may be further significantly reduced. A method of forming the bottom dielectric layer 118 includes, but is not limited to, first depositing a dielectric material with a faster etching rate (such as an oxide) in the trench 112 to form on the sidewall 112s and the bottom surface 112b of the trench 112, then depositing a dielectric material with a slower etching rate (such as an oxide) and performing a planarization process, followed by using an etching process. Due to the process, the convex curved surface CC of the top 118t is generally located between the two sidewalls 112s, so if the trench 112 vertically extends to the plane of the figure, the convex curved surface CC may also extend in the trench 112. This kind of structure of the bottom dielectric layer 118 with a triangular profile further has the effect of reducing the Miller capacitance effect of the gate on the drain, thereby accelerating the switching speed of the device. On the other hand, from the perspective of the structure of the gate 114, the gate 114 is also different from a gate with a normal rectangular cross-section. The gate 114 in the embodiment has a profile complementary to the top 118t of the bottom dielectric layer 118, so a bottom 114b of the gate 114 has a concave curved surface, and a cross-section of the bottom 114b has a dovetail profile. In FIG. 1, if the epitaxial layer 102 is an N-type epitaxial layer 102, a shallow base region 120 and a thick base region 122 may further be formed on both sides of the trench 112. The shallow base region 120 and the thick base region 122 are P-type doped regions. The thick base region 122 is under the source region 108 and the heavily doped region 110, but does not connect with the trench gate structure 104. The shallow base region 120 surrounds the foregoing doped regions (such as the source region 108 and the heavily doped region 110) and connects with the trench gate structure 104. However, the disclosure is not limited thereto. There may be other doped regions in the epitaxial layer 102 to prevent leakage, increase breakdown voltage, etc.

In some embodiments, a thickness of the epitaxial layer 102 is, for example, 5 µm to 100 µm; a doping concentration of the epitaxial layer 102 is, for example, 1E15 cm⁻³ to 6E16 cm⁻³. In some embodiments, a thickness of the source region 108 is, for example, 0.3 µm to 0.6 µm; a doping concentration of the source region 108 is, for example, 1E19 cm⁻³ to 1E21 cm⁻³. In some embodiments, a thickness of the heavily doped region 110 is, for example, 0.3 µm to 0.6 µm; a doping concentration of the heavily doped region 110 is, for example, 1E19 cm⁻³ to 1E21 cm⁻³. In some embodiments, a thickness of the shallow base region 120 is, for example, 0.7 µm to 1 µm; a doping concentration of the shallow base region 120 is, for example, 5E16 cm⁻³ to 5E17 cm⁻³. A thickness of the thick base region 122 is, for example, 1 µm to 1.5 µm; a doping concentration of the thick base region 122 is, for example, 5E17 cm⁻³ to 1E19 cm⁻³. In some embodiments, the thickness t2 of the bottom dielectric layer 118 is, for example, 0.2 µm to 0.4 µm. In some embodiments, the thickness t1 of the gate oxide layer 116 is, for example, 0.02 µm to 0.1 µm.

The foregoing numerical ranges are ranges applied in some embodiments, but the disclosure is not limited to the foregoing ranges.

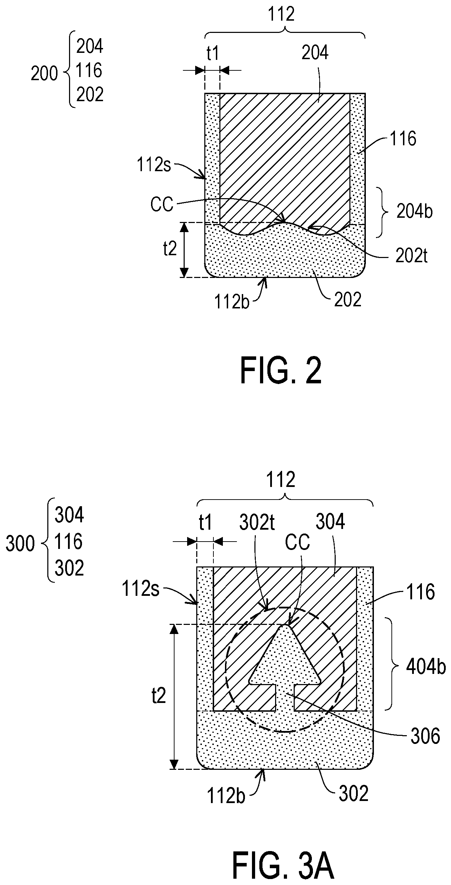

FIG. 2 is a schematic cross-sectional view of an example of a gate structure in a trench power device according to an embodiment of the disclosure. Please refer to FIG. 2. The gate structure in the trench power device of the foregoing embodiment may also be changed to a trench gate structure 200, while the remaining parts are the same as or similar to FIG. 1, so they are not shown for the purpose of brevity. The trench gate structure 200 includes a bottom dielectric layer 202, a gate 204, and the gate oxide layer 116. Relative positions of the gate 204 with respect to the bottom dielectric layer 202 and the gate oxide layer 116 are the same as in the foregoing embodiment. The difference is that a cross-section of a top 202t of the bottom dielectric layer 202 has a wavy profile, and the top 202t has the convex curved surface CC as in FIG. 1, so the trench gate structure 200 in FIG. 2 also has the feature of avoiding the phenomenon of excessive electric field at the bottom and corner of the trench 112. A method of forming the bottom dielectric layer 202 may include, but is not limited to, first executing the method of forming the bottom dielectric layer 118 in FIG. 1, then conformally depositing a layer of oxide thereon, followed by performing an oxide etching process until the bottom dielectric layer 202 has a wavy profile. The gate 204 in FIG. 2 has a profile complementary to the top 202t of the bottom dielectric layer 202, so a bottom 204b of the gate 204 has a concave curved surface, and a cross-section of the bottom 204b also has a wavy profile.

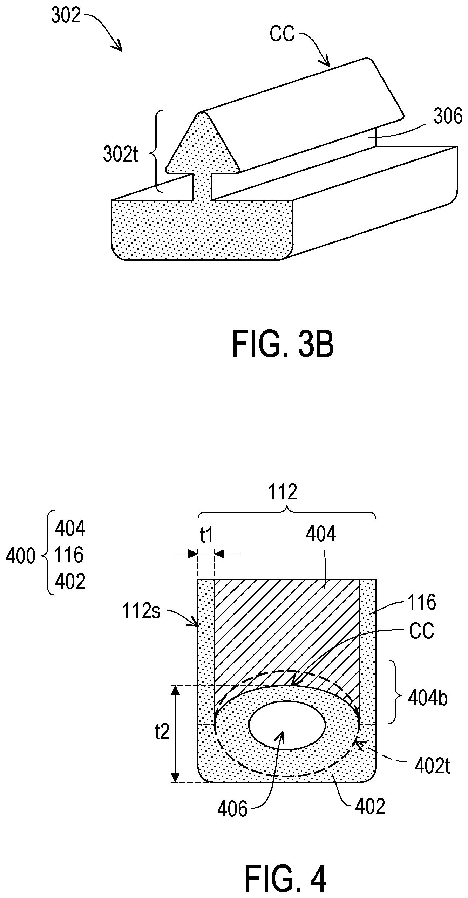

FIG. 3A is a schematic cross-sectional view of another example of a gate structure in a trench power device according to an embodiment of the disclosure. Please refer to FIG. 3A. The gate structure in the trench power device of the foregoing embodiment may also be changed to a trench gate structure 300, while the remaining parts are the same as or similar to FIG. 1, so they are not shown for the purpose of brevity. The trench gate structure 300 includes a bottom dielectric layer 302, a gate 304, and the gate oxide layer 116. Relative positions of the gate 304 with respect to the bottom dielectric layer 302 and the gate oxide layer 116 are the same as in the foregoing embodiment. The difference is that a top 302t of the bottom dielectric layer 302 is a ridge bar, and a cross-section of the ridge bar has a triangular profile. Since the trench 112 is actually a strip that vertically extends to the plane of the figure, the perspective view of the bottom dielectric layer 302 formed therein is shown in FIG. 3B.

In FIG. 3B, the top 302t of the bottom dielectric layer 302 has the convex curved surface CC as in FIG. 1, so the trench gate structure 300 in FIG. 3A also has the effect of avoiding the phenomenon of excessive electric field at the bottom and corner of the trench 112, and may significantly reduce the phenomenon of gate voids and reduce the Miller capacitance effect of the gate on the drain. The bottom dielectric layer 302 in FIG. 3A further includes a necking portion 306, located between the ridge bar and the bottom surface 112b of the trench 112. A method of forming the bottom dielectric layer 302 may include, but is not limited to, first executing the method of forming the bottom dielectric layer 118 in FIG. 1, and then continuing to etch the oxide to obtain the top 302t that is like a ridge bar. The gate 304 in FIG. 3A has a profile complementary to the top 302t of the bottom dielectric layer 302, so a bottom 304b of the gate 304 has a concave curved surface, and a cross-section of the bottom 204b has an arrow profile.

FIG. 4 is a schematic cross-sectional view of yet another example of a gate structure in a trench power device according to an embodiment of the disclosure. Please refer to FIG. 4. The gate structure in the trench power device of the foregoing embodiment may also be changed to a trench gate structure 400, while the remaining parts are the same as or similar to FIG. 1, so they are not shown for the purpose of brevity. The trench gate structure 400 includes a bottom dielectric layer 402, a gate 404, and the gate oxide layer 116. Relative positions of the gate 404 with respect to the bottom dielectric layer 402 and the gate oxide layer 116 are the same as in the foregoing embodiment. The difference is that a cross-section of a top 402t of the bottom dielectric layer 402 has a semi-circular profile. The top 402t has the convex curved surface CC as in FIG. 1, so the trench gate structure 400 in FIG. 2 also has the effect of avoiding the phenomenon of excessive electric field at the bottom and corner of the trench 112, and may reduce the phenomenon of gate voids. In some embodiments, the bottom dielectric layer 402 might have a hole 406. A method of forming the bottom dielectric layer 402 may include, but is not limited to, first executing the method of forming the bottom dielectric layer 118 in FIG. 1, and then performing high-temperature annealing, during which generating the hole 406 in the bottom dielectric layer 402. The gate 404 in FIG. 4 has a profile complementary to the top 402t of the bottom dielectric layer 402, so a bottom 404b of the gate 404 has a concave curved surface, and a cross-section of the bottom 404b also has a semi-circular profile.

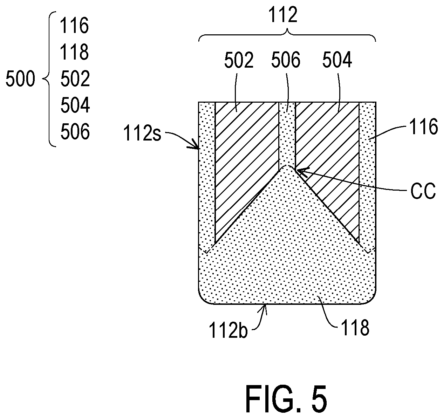

FIG. 5 is a schematic cross-sectional view of yet another example of a gate structure in a trench power device according to an embodiment of the disclosure. Please refer to FIG. 5. The gate structure in the trench power device of the foregoing embodiment may also be changed to a trench gate structure 500, while the remaining parts are the same as or similar to FIG. 1, so they are not shown for the purpose of brevity. The trench gate structure 500 includes the gate oxide layer 116, the bottom dielectric layer 118, a split gate 502, a split gate 504, and an isolation layer 506. The difference between the trench gate structure 500 and the trench gate structure 104 in FIG. 1 is that the gate is changed to the split gate 502 and the split gate 504. The split gate 502 and the split gate 504 may reduce the Miller capacitance, thereby increasing the switching speed of the device. A method of forming the split gate 502 and the split gate 504 may include, but is not limited to, conformally depositing a gate material above the bottom dielectric layer 118 after forming the gate oxide layer 116 and the bottom dielectric layer 118. That is, the shape of the gate on the inside of the trench 112 may also be a triangular shape, and a gate material may be heavily doped polysilicon or a metal conductive material. After the gate material is deposited, anisotropic etching is performed to form the split gate structure, and then the isolation layer 506 is formed between the split gates on both sides of the trench 112. The split gate 502 and the split gate 504 in FIG. 5 may also be used in the structures in FIG. 2, FIG. 3A, and FIG. 4, so details will not be described again.

The trench power device of the embodiment of the disclosure may withstand high voltage at the bottom and corner of the trench, being adapted to serve as a key component in electric vehicles or for application in other high-power demand devices.

Although the disclosure has been disclosed in the above embodiments, the embodiments are not intended to limit the disclosure. Persons skilled in the art may make some changes and modifications without departing from the spirit and scope of the disclosure. Therefore, the protection scope of the disclosure shall be defined by the appended claims.

## Claims

1. A trench power device, comprising:
a substrate (100), having a first surface (100a) and a second surface (100b) opposite to each other;
an epitaxial layer (102), formed on the first surface (100a) of the substrate (100) and having a trench (112);
a trench gate structure (104, 200, 300, 400, 500), formed in the trench (112) of the epitaxial layer (102);
a drain layer (106), formed on the second surface (100b) of the substrate (100); and
a source region (108), formed in the epitaxial layer (102) on both sides of the trench gate structure (104, 200, 300, 400, 500), wherein the trench gate structure (104, 200, 300, 400, 500) comprises:
a gate (114, 204, 304, 404), formed in the trench (112);
a gate oxide layer (116), formed between the gate (114, 204, 304, 404) and a sidewall (112s) of the trench (112); and
a bottom dielectric layer (118, 202, 302, 402), formed between the gate (114, 204, 304, 404) and a bottom surface (112b) of the trench (112), wherein a thickness (t2) of the bottom dielectric layer (118) is greater than a thickness (t1) of the gate oxide layer (116), and a top (118t, 202t, 302t, 402t) of the bottom dielectric layer (118, 202, 302, 402) comprises a convex curved surface.

2. The trench power device according to claim 1, wherein a cross-section of the top (118t) of the bottom dielectric layer (118) has a triangular profile.

3. The trench power device according to claim 1, wherein a cross-section of the top (202t) of the bottom dielectric layer (202) has a wavy profile.

4. The trench power device according to claim 1, wherein the top (302t) of the bottom dielectric layer (302) is a ridge bar, and a cross-section of the ridge bar has a triangular profile.

5. The trench power device according to claim 4, wherein the bottom dielectric layer (302) further comprises a necking portion (306), located between the ridge bar and the bottom surface (112b) of the trench (112).

6. The trench power device according to claim 1, wherein a cross-section of the top (402t) of the bottom dielectric layer (402) has a semi-circular profile.

7. The trench power device according to claim 6, wherein the bottom dielectric layer (402) has a hole (406).

8. The trench power device according to claim 1, wherein a material of the bottom dielectric layer (118) comprises silicon oxide, silicon nitride or metal oxide.

9. The trench power device according to claim 1, wherein a material of the substrate (100) comprises Si, SiC, GaN or GaAs.

10. The trench power device according to claim 1, wherein the substrate (100) comprises a glass substrate or a sapphire substrate.

11. A trench power device, comprising:
a substrate (100), having a first surface (100a) and a second surface (100b) opposite to each other;
an epitaxial layer (102), formed on the first surface (100a) of the substrate (100) and having a trench (112);
a trench gate structure (104, 200, 300, 400, 500), formed in the trench (112) of the epitaxial layer (102);
a drain layer (106), formed on the second surface (100b) of the substrate (100); and
a source region (108), formed in the epitaxial layer (102) on both sides of the trench gate structure (104, 200, 300, 400, 500), wherein the trench gate structure (104, 200, 300, 400, 500) comprises:
a gate (114, 204, 304, 404), formed in the trench (112), wherein a bottom (114b, 204b, 304b, 404b) of the gate (114, 204, 304, 404) has a concave curved surface;
a gate oxide layer (116), formed between the gate (114, 204, 304, 404) and a sidewall (112s) of the trench (112); and
a bottom dielectric layer (118, 202, 302, 402), formed between the gate (114, 204, 304, 404) and a bottom surface (112b) of the trench (112).

12. The trench power device according to claim 11, wherein a cross-section of the bottom (114b) of the gate (114) has a dovetail profile.

13. The trench power device according to claim 11, wherein a cross-section of the bottom (204b) of the gate (204) has a wavy profile.

14. The trench power device according to claim 11, wherein a cross-section of the bottom (404b) of the gate (404) has a semi-circular profile.

15. The trench power device according to claim 11, wherein a cross-section of the bottom (304b) of the gate (304) has an arrow profile.

16. The trench power device according to claim 11, wherein the gate (114, 204, 304, 404, 502, 504) is a single gate (114, 204, 304, 404) or a split gate (502, 504).

17. The trench power device according to claim 16, wherein there is an isolation layer (506) between the split gates (502, 504).

18. The trench power device according to claim 11, wherein a material of the bottom dielectric layer (118, 202, 302, 402) comprises silicon oxide, silicon nitride or metal oxide.

19. The trench power device according to claim 11, wherein a material of the substrate (100) comprises Si, SiC, GaN or GaAs.

20. The trench power device according to claim 11, wherein a material of the substrate (100) comprises a glass substrate or a sapphire substrate.

## Amended claims

### Amended claims in accordance with Rule 137(2) EPC.

1. A trench power device, comprising:
a substrate (100), having a first surface (100a) and a second surface (100b) opposite to each other;
an epitaxial layer (102), formed on the first surface (100a) of the substrate (100) and having a trench (112);
a trench gate structure (104, 300, 500), formed in the trench (112) of the epitaxial layer (102);
a drain layer (106), formed on the second surface (100b) of the substrate (100); and
a source region (108), formed in the epitaxial layer (102) on both sides of the trench gate structure (104, 300, 500), wherein the trench gate structure (104, 300, 500) comprises:
a gate (114, 304, 502, 504), formed in the trench (112);
a gate oxide layer (116), formed between the gate (114, 304, 502, 504) and a sidewall (112s) of the trench (112); and
the trench power device **characterized by** further comprising:
a bottom dielectric layer (118, 302), formed at the bottom of trench (112) and in direct contact with a bottom (114b, 304b) of the gate (114, 304, 502, 504) and a bottom surface (112b) of the trench (112), wherein
a top (118t, 302t) of the bottom dielectric layer (118, 302) is a ridge bar, a cross-section of the ridge bar has a triangular profile, a thickness (t2) of the bottom dielectric layer (118) is greater than a thickness (t1) of the gate oxide layer (116), and a top (118t, 302t) of the ridge bar comprises a convex curved surface (CC).

2. The trench power device according to claim 1, wherein the bottom dielectric layer (302) further comprises a necking portion (306), located between the ridge bar and the bottom surface (112b) of the trench (112).

3. The trench power device according to claim 1, wherein a material of the bottom dielectric layer (118) comprises silicon oxide, silicon nitride or metal oxide.

4. The trench power device according to claim 1, wherein a material of the substrate (100) comprises Si, SiC, GaN or GaAs.

5. The trench power device according to claim 1, wherein the substrate (100) comprises a glass substrate or a sapphire substrate.

6. The trench power device according to claim 1,
wherein the bottom (114b, 304b) of the gate (114, 304) has a concave curved surface.

7. The trench power device according to claim 6, wherein the gate (114, 304) is a single gate (114, 304).

8. The trench power device according to claim 6, wherein the gate (502, 504) consists of two split gates (502, 504), an isolation layer (506) is disposed between the two split gates (502, 504), and the isolation layer (506) is vertically disposed on the convex curved surface (CC) of the bottom dielectric layer (118).
